(19) **Europäisches Patentamt / European Patent Office / Office européen des brevets**

(11) **EP 1 850 352 A1**

(12) **EUROPEAN PATENT APPLICATION**
published in accordance with Art. 158(3) EPC

(43) Date of publication:
**31.10.2007 Bulletin 2007/44**

(51) Int Cl.:
*H01B 1/22* (2006.01)  *H05K 1/09* (2006.01)

(21) Application number: **06712054.3**

(22) Date of filing: **20.01.2006**

(86) International application number:
**PCT/JP2006/300829**

(87) International publication number:
**WO 2006/080247 (03.08.2006 Gazette 2006/31)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.01.2005 JP 2005016965**

(71) Applicants:
• **FUJIKURA KASEI CO., LTD.**
  **Itabashi-ku,**
  **Tokyo 174-0046 (JP)**
• **Asahi Kasei EMD Corporation**
  **Tokyo 160-0023 (JP)**

(72) Inventors:
• **HIRAKAWA, Yohei**
  **FUJIKURA KASEI CO., LTD.**
  **Kitakatsushika-gun, Saitama 3400203 (JP)**

• **WAKABAYASHI, Katsutomo**
  **FUJIKURA KASEI CO., LTD.**
  **Kitakatsushika-gun, Saitama, 3400203 (JP)**
• **YOTSUYANAGI, Yuta**
  **FUJIKURA KASEI CO., LTD.**
  **Kitakatsushika-gun, Saitama 3400203 (JP)**
• **TANAKA, Norihito**
  **Fuji-shi, Shizuoka, 4168501 (JP)**

(74) Representative: **Carter, Stephen John et al**
  **Mewburn Ellis LLP**
  **York House**
  **23 Kingsway**
  **London WC2B 6HP (GB)**

(54) **CONDUCTIVE PASTE**

(57) A conductive paste that includes a binder containing a thermosetting resin and conductive particles, in which the lowest exothermic peak temperature $T_1$ (degrees C) among at least one exothermic peak obtained by differential scanning calorimetry of the binder and the lowest endothermic peak temperature $t_1$ (degrees C) among at least one endothermic peak obtained by differential scanning calorimetry of the conductive particles satisfy the relation $t_1 - 20 < T_1$ ... (1), thereby achieving good conductivity and excellent conductive connection reliability.

EP 1 850 352 A1

**Description**

TECHNICAL FIELD

The present invention relates to a conductive paste that is favorably used, for example, for filling of via holes in a printed circuit board.

Priority is claimed on Japanese Patent Application No. 2005-16965, filed on January 25, 2005, the content of which is incorporated herein by reference.

BACKGROUND ART

Materials containing silver powder, copper powder, and silver-coated copper powder have conventionally been used as conductive particles in conductive pastes used for filling of via holes in printed circuit boards. However, since these conductive particles generally have a high melting point, fusion splice between particles by heat treatment is hindered. As a result, they have the drawback of exhibiting poor conductive connection reliability in thermal shock tests and moisture resistance tests and the like.

Patent Document 1 discloses art that increases the conductive connection reliability by forming metallic bonds between alloy layers that are formed on the outer peripheral portions of particles and consist of metallic particles having a low melting point.

In addition, Patent Documents 2 to 5 disclose art in which alloy particles are fusion spliced via thermal processing, and by using alloy particles whose melting points change, a conductive paste with stabilized conductivity is achieved. Among these, Patent Document 2 discloses conductive particles that do not substantially contain lead (Pb), exhibit an exothermic peak by differential scanning calorimetry, and have a plurality of melting points that are defined as endothermic peak temperatures by differential scanning calorimetry. The lowest temperature melting point among the plurality of melting points (initial lowest melting point) is considered to be caused by the melting of the surface portion of the particles. Particularly the surface portion of the conductive particles is provided with a component that exhibits this initial lowest melting point. Therefore, when the conductive particles are heated to a temperature of the initial lowest melting point or higher by heat treatment, at least the surface portion thereof melts, and as a result, firm connectability is exhibited between the conductive particles so that conductivity is stabilized.

Also, Patent Documents 6 and 7 disclose conductive pastes that employ specified conductive particles and epoxy resins.

Patent Document 1: Japanese Unexamined Patent Application, First Publication No. 2002-94242

Patent Document 2: Japanese Unexamined Patent Application, First Publication No. 2004-234900

Patent Document 3: Japanese Unexamined Patent Application, First Publication No. 2004-223559

Patent Document 4: Japanese Unexamined Patent Application, First Publication No. 2004-363052

Patent Document 5: Japanese Unexamined Patent Application, First Publication No. 2005-5054

Patent Document 6: Japanese Patent Granted Publication No. 3038210

Patent Document 7: Japanese Patent Granted Publication No. 2603053

DISCLOSURE OF INVENTION

PROBLEM TO BE SOLVED BY THE INVENTION

However, the conductive paste that includes the conductive particles disclosed in Patent Document 1 relies on interlayer connections of particles solely with metal bonding without using a thermosetting resin. Therefore, problems in the conductive connection reliability arise due to the generation of cracks etc. in reliability tests caused by the difference in the coefficient of thermal expansion with an insulation material.

Also, even when using a conductive paste that includes a thermosetting resin such as those disclosed in Patent Documents 2 to 5 and Patent Documents 6 and 7, conductivity is not sufficiently stabilized when the diameter of the via holes is small, leading to a tendency for the conductive connection reliability to be inadequate.

The present invention was achieved in view of the above circumstances, and has as its object to provide a conductive paste with favorable conductivity and excellent conductive connection reliability.

MEANS FOR SOLVING THE PROBLEMS

The present inventors have perfected this invention as the result of concerted study, with the discovery that a combination of conductive particles and binder included in a conductive paste imparts an effect on the conductivity of the conductive paste and the reliability thereof.

The conductive paste of the present invention includes a binder containing a thermosetting resin and conductive particles, in which the lowest exothermic peak temperature $T_1$ (degrees C) among at least one exothermic peak obtained by differential scanning calorimetry of the binder and the lowest endothermic peak temperature $t_1$ (degrees C) among at least one endothermic peak obtained by differential scanning calorimetry of the conductive particles satisfy Equation (1).

$$t_1 - 20 < T_1 \cdots (1)$$

The conductive particles preferably have at least one exothermic peak by differential scanning calorimetry.

Also, the conductive particles preferably have alloy particles (I) that have at least one exothermic peak by differential scanning calorimetry and alloy particles (II) that have an endothermic peak at the endothermic peak temperature $t_1$.

It is preferable that the conductive paste contains 0.1 to 4.0 parts by weight of an oxide film remover relative to 100 parts by weight of the conductive particles.

The conductive paste of the present invention is suitable for filling via holes in a printed circuit board.

EFFECTS OF THE INVENTION

In accordance with the present invention, it is possible to provide a conductive paste with good conductivity and excellent conductive connection reliability.

BEST MODE FOR CARRYING OUT THE INVENTION

The present invention shall be described in detail hereinbelow.

A conductive paste of the present invention includes a binder that contains a thermosetting resin and conductive particles, in which the lowest exothermic peak temperature $T_1$ (degrees C) among at least one exothermic peak obtained by differential scanning calorimetry of the binder and the lowest endothermic peak temperature $t_1$ (degrees C) among at least one endothermic peak obtained by differential scanning calorimetry of the conductive particles satisfy the equation (1). Here, the exothermic peak of the binder is caused by curing of the thermosetting resin that is included in the binder; therefore, the exothermic peak temperature serves as an index of curing temperature. Meanwhile, the endothermic peak of the conductive particles is caused by the melting of the conductive particles, and the endothermic peak temperature can be regarded as the melting point. Hereinbelow, the lowest endothermic peak temperature $t_1$ of the conductive particles is referred to as the lowest melting point.

$$t_1 - 20 < T_1 \cdots (1)$$

There may be one or more of the exothermic peak of the binder and the endothermic peak of the conductive particles.

In the case of the conductive paste satisfying the relation of Equation (1), that is, the lowest exothermic peak temperature $T_1$ (degrees C) among the exothermic peaks of the binder being a higher temperature than a temperature that is 20 degrees C below the lowest melting point $t_1$ (degrees C) of the conductive particles, when heat treatment is applied to the conductive paste filled in via holes or the like in the printed circuit board, it can be presumed that at least a portion of the conductive particles will melt while favorably dispersing in the binder and, in the state of the conductive particles being fusion spliced to each other, the curing of the binder proceeds. Thereby, the conductivity of the conductive paste is excellent after curing and conductive connection reliability is favorable. On the other hand, when the conductive paste does not satisfy the relationship of Equation (1), that is, the lowest exothermic peak temperature $T_1$ (degrees C) among the exothermic peaks of the binder being less than or equal to a temperature that is 20 degrees C below the lowest melting point $t_1$ (degrees C) of the conductive particles, the curing of the binder proceeds before the conductive particles that have dispersed in the binder have undergone fusion splice to each other. For that reason, the mutual fusion splice of the conductive particles is considered to be impeded, and as a result the conductivity of the conductive paste after curing is insufficient and the conductive connection reliability ends up falling.

The lowest exothermic peak temperature $T_1$ (degrees C) among the exothermic peaks of the binder is from the standpoint of thermal stability preferably 300 degrees C or less and more preferably 250 degrees C or less. Also, the lowest melting point $t_1$ of the conductive particles is preferably in the range of 40 to 250 degrees C. A melting point in this range causes the conductive particles to undergo fusion splice without affecting other electronic components and so can express higher conductivity and conductive connection reliability.

There are no particular restrictions on the type of thermosetting resin included in the binder, provided the conductive paste contains a binder and conductive particles so as to satisfy the relationship of Equation (1). Examples include a resol-type phenol resin, a novolac-type phenol resin, a bisphenol A-type epoxy resin, a bisphenol F-type epoxy resin, a novolac-type epoxy resin, a liquid epoxy compound that has one or more glycidyl groups in one molecule, a melamine resin, a urea resin, a xylene resin, an alkyd resin, an unsaturated polyester resin, an acrylic resin, a polyimide resin, a flan resin, a urethane resin, a bismaleimide triazine resin, and a silicone resin, with an epoxy resin being preferred. Also, the thermosetting resin may be included in the conductive paste in the form of a monomer. A curing agent may be contained in the binder, with examples including an amine system epoxy curing agent, an acid anhydride system epoxy curing agent, an isocyanate system curing agent, and an imidazole system curing agent, etc. These thermosetting resins and curing agents may be used alone or in the form of a mixture of two or more thereof.

In addition, a thermoplastic resin may be contained in the binder if needed.

Also, there are no particular restrictions on the average particle diameter or specific composition of the conductive particles, provided the conductive paste contains a binder and conductive particles so as to satisfy the relationship of Equation (1). However, from the standpoint of conductivity, the average particle diameter is preferably 1 to 50 $\mu$m, and more preferably 1 to 30 $\mu$m. In the case of the conductive paste containing conductive particles with an average particle diameter exceeding 30 $\mu$m, a fewer number of particles are filled in the via holes in the printed circuit board, and voids between the conductive particles increase. This tends to hinder the development of stable conductivity. On the other hand, an average particle diameter of less than 1 $\mu$m increases the specific surface area of the conductive particles, so that the surface easily oxidizes. Moreover, since the viscosity of the obtained conductive paste increases, a large quantity of a diluent becomes necessary. As a result, voids tend to readily occur in the via holes.

As example compositions of the conductive particles, an alloy composition that satisfies the conditions (1) to (6) as presented below can be shown as preferable; an alloy of 63 percent by weight Sn and 37 percent by weight Pb, an alloy of 42 percent by weight Sn and 58 percent by weight Bi, an alloy of 91 percent by weight Sn and 9 percent by weight Zn, an alloy of 89 percent by weight Sn, 8 percent by weight Zn, and 3 percent by weight Bi, and an alloy of 93 percent by weight Sn, 3.5 percent by weight Ag, 0.5 percent by weight Bi, and 3 percent by weight In.

(1) Containing Cu and Sn as a first metal type, containing at least two types selected from a group consisting of Ag, Bi, In and Zn as a second metal type, and containing at least one type selected from a group consisting of Sb, Al, Ga, Au, Si, Ge, Co, W, Ta, Ti, Ni, Pt, Mg, Mn, Mo, Cr, and P as a third metal type.

(2) The content of Cu is 10 to 90 percent by weight, and the content of Sn is 5 to 80 percent by weight.

(3) In the case of containing Ag, the Ag content is 0.5 to 20 percent by weight, in the case of containing Bi, the Bi content is 0.5 to 15 percent by weight, in the case of containing In, the In content is 0.5 to 15 percent by weight, and in the case of containing Zn, the Zn content is 1 to 5 percent by weight.

(4) The total content of the third metal type is 0.01 to 3 percent by weight.

(5) The weight composition ratio Cu/Sn of Cu and Sn is 0.5 or more.

(6) The weight composition ratio Bi/In of Bi and In is 1 or less, and the sum In + Bi of the content of Bi and In is 50 percent by weight or less.

The conductive particles may consist of one type of particle having the above alloy composition, but for example may be a particle mixture including particles having such an alloy composition, and silver particles, copper particles, nickel particles, and silver-plated copper particles.

Also, more preferably, it is preferable to use particles having at least one exothermic peak by differential scanning calorimetry as the conductive particles.

The possession of an exothermic peak by the conductive particles suggests that the conductive particles have a metastable phase. A metastable phase means that a phase change readily occurs with heating. Therefore, in the case of heating conductive particles that have a metastable phase, at least one melting point is considered to change due to the phase change of the metastable phase. Thus, in the case of heating at a temperature not less than the lowest melting point the conductive particles including the metastable phase so that the melting point rises due to such a phase change, a portion that exhibits at least the lowest melting point melts by the first heat treatment. However, since the melting point of the portion that has melted by the first heat treatment rises, a characteristic is expressed in which re-melting will not occur in the second and subsequent heat treatments. For that reason, when the conductive paste that includes these conductive particles is filled into via holes in a printed circuit board and subjected to a heat treatment for curing, the portion in the conductive particles that exhibits the melting point not above the thermal treatment temperature melts, whereby the conductive particles undergo fusion splice to each other. By performing such heat treatment for curing, the melting point of the conductive particles that include the metastable phase rises as a result of undergoing a phase change. Thereafter, the portion will not readily remelt even if a heat treatment is applied in the mode of the mounted article. Therefore, by using conductive particles that have an exothermic peak, it is possible to achieve excellent heat resistance reliability in which the conductivity does not decrease due to the thermal history. The change of the melting point can be confirmed from the change in the endothermic peak temperature by differential scanning calorimetry. Also, it is preferable for the rise in the melting point to be at least 2 degrees C. Furthermore, the value of the melting point that has risen due to the heat treatment is preferably not less than 250 degrees C.

The conductive particles that have at least one exothermic peak may be constituted from one type of conductive particle, or may be mixed particles consisting of two or more types of conductive particles. A suitable example would include mixed particles that contain alloy particles (I) having at least one exothermic peak by differential scanning calorimetry, i.e., having at least one metastable phase, and alloy particles (II) that have an endothermic peak at the endothermic peak temperature $t_1$ (degrees C). Performing heat treatment on the mixed particles at a temperature not less than the endothermic peak temperature $t_1$ (degrees C) causes at least a portion of the alloy particles (II) to melt and undergo atomic diffusion with the alloy particles (I). As a result, a new phase is formed by the bonding of the metastable phase in the alloy particles (I) and at least a portion of the alloy particles (II). If the phase that is thus formed exhibits a melting point that is higher than the endothermic peak temperature $t_1$ (degrees C), even if the newly formed phase is again subjected to heat treatment, it will not readily remelt. Therefore, by filling via holes or the like with a conductive paste that includes such mixed particles and heating to perform curing, the conductive paste will not readily remelt even if subjected to heat treatment again in the mode of a mounted article thereafter. As a result, high heat resistance reliability can be achieved. Also, the exothermic peak of the alloy particles (I) is preferably in a range of 50 to 400 (degrees C).

There is no particular restriction on the ratio of the alloy particles (I) to the alloy particles (II) in the mixed particles. However, including not less than 20 percent by weight of the alloy particles (I) results in a higher conductivity, and so can achieve a high conductive connection reliability. Moreover, having alloy particles (I) of 40 to 90 percent by weight and alloy particles (II) of 10 to 60 percent by weight makes the conductive connection reliability more excellent, which is preferred.

The mixed particles in this case may include silver particles, copper particles, nickel particles, and silver-plated copper particles.

There are no particular restrictions on the method of manufacturing the alloy particles (I) and the alloy particles (II). However, in order to form the metastable phase and the stable alloy phase in the alloy particles, it is preferred to adopt an inert gas atomization method that is a rapid solidification method. Moreover, although nitrogen gas, argon gas, helium gas, etc. are usually used as the inert gas by this method, it is preferable to use helium gas among these. A cooling rate of 500 degrees C/sec or higher is preferred, and 1000 degrees C/sec or higher is more preferred.

Also, the surfaces of the alloy particles (I) and the alloy particles (II) may be coated with a metal. As a coating method in such a case, it is possible to manufacture the particles by a method that performs surface treatments on the particles with a plating method, a sputtering method, a vapor method, a spray coating method, a dip method, or the like and thermally diffuses a specified metal in a selective manner. Examples of a plating method include an electroless plating method and an electroplating method, and examples of the electroless plating method include immersion plating.

The preferred composition of the alloy particles (I) is a composition that consists of at least one element chosen from Cu, Sn, and a group that consists of Ag, Bi, and In. On the other hand, the preferred composition of the alloy particles (II) is a composition that consists of at least one element chosen from In, Sn, and a group consisting of Cu, Ag and Bi.

In addition, in the case of the conductive particles that have at least one exothermic peak consisting of one type of metal, conductive particles are preferred to have at least one exothermic peak by differential scanning calorimetry and also to have a plurality of endothermic peaks, with the lowest endothermic peak among those endothermic peaks depending on the melting of at least a portion of the surface portion of the conductive particles. The lowest temperature endothermic peak among the plurality of endothermic peaks depending on the melting of at least a portion of the surface portion of the conductive particles means that the conductive particles have a plurality of melting points, and at least a portion of the surface portion of the conductive particles exhibits the lowest melting point $t_1$ (degrees C). Thereby, at least a portion of the surface portion of such conductive particles melts by heat treatment at a temperature not less than the lowest melting point $t_1$ (degrees C), facilitating fusion splice between the particles to each other strongly. Also, since the conductive particles being fusion spliced with the electrode metal portions of the substrate, it is possible to achieve higher conductivity and conductive connection reliability. Also, since such conductive particles simultaneously have a high melting point phase that hardly melts, there is no risk of excessive melting. Furthermore, by heat treatment at a temperature not less than the lowest melting point $t_1$ (degrees C), the low melting point phase of the surface melts, and the atomic dispersion due to the existence of the metastable phase is accelerated, so that that the melting point rises. As a result, the conductivity of the conductive particles and the heat resistance reliability are both extremely excellent. Here, the surface portion refers to the portion extending 0.2 r from the particle surface, with r being the radius of the conductive particles.

Conductive particles that have at least one exothermic peak by differential scanning calorimetry and also a plurality of endothermic peaks with the lowest endothermic peak among those endothermic peaks depending on the melting of at least a portion of the surface portion of the conductive particles, can be achieved by a particle manufacturing process that consists of the rapid solidification method that cools a metal melt at a rate of not less than 500 degrees C/sec using an inert gas as a cooling medium. Also, if needed, a surface treatment process may be performed that consists of surface treatment by a plating method, a sputtering method, a vapor method, a spray coating method, a dip method, or the like and thermally diffusing a specified metal in a selective manner. Examples of a plating method include an electroless plating method and an electroplating method, and examples of the electroless plating method include immersion plating.

The oxygen content of the conductive particles is preferably 0.1 to 3.0 percent by weight and more preferably 0.2 to 2.5 percent by weight, and still more preferably 0.3 to 2.0 percent by weight. When in this range, the ion-migration resistance, conductivity, conductive connection reliability, and dispersibility into the binder become favorable.

The conductive paste is obtained by mixing the binder and the conductive particles described above in a planetary mixer or the like. A suitable ratio of the binder and the conductive particles, based on the sum of both, is the binder in the range of 3 to 16 percent by weight and the conductive particles in the range of 84 to 97 percent by weight. Such ratios allow for sufficient amounts of the conductive particles and the binder, with the fusion splice between the conductive particles to each other being favorable and the reliability thereof also increasing.

It is preferable to blend an oxide film remover in the conductive paste. Blending an oxide film remover can remove the surface oxide film of the conductive particles, and as a result, can improve the fusion splice. As an oxide film remover, in addition to a flux and surface finishing agents which are generally available on the market, it is also possible to use a carboxylic acid such as adipic acid and stearic acid, a blocked carboxylic acid that blocks the activity of the carboxylic acid by using vinyl ether or the like, an amin such as stearylamine, and a blocked amine that blocks the activity of amin using a boron system compound or the like. The blending quantity of the oxide film remover is preferably 0.1 to 4.0 parts by weight relative to 100 parts by weight of the conductive particles. There is no effect with an amount of less than 0.1 parts by weight, and the conductive connection reliability falls when the amount exceeds 4 parts by weight.

There are no particular restrictions on the method of adding the oxide film remover. The oxide film remover may be directly added when mixing the conductive particles and the binder to form the paste, or the conductive particles may be covered in advance with the oxide film remover. As a covering method, it is possible to suitably use a device that is used for mixing powders or mixing and dispersing a powder and a liquid, with no particular restrictions on the model. In this case, the oxide film remover may be directly made into contact with the conductive particles, or the oxide film remover may be dissolved or dispersed in a suitable liquid beforehand, with the conductive particles being poured therein to be treated as slurry. This kind of method enables the conductive particles to be covered uniformly and reliably with an oxide film remover. Thereafter, it is possible to carry out a drying process with a vacuum drier or the like if needed.

Also, the conductive paste may as required additionally contain other components such as a dispersant and an organic solvent as a diluent.

Such a conductive paste can be used for various uses, and is particularly suited to through via holes and non-through via holes provided on a multi-layer printed circuit board, and to mounted portions such as electrical components. The conductive paste is printed and filled in via holes and then hardened by heat treatment. Thereby, the conductive particles are fusion spliced to each other in a highly dispersed state and are favorably connected to the electrode metal portions of the substrate, enabling the manufacture of a multi-layer printed circuit board that has excellent conductive connection reliability. In the heat treatment, a publicly known device can be used, such as a box-type hot-blast stove, a continuous-type hot-blast stove, a muffle-type heating furnace, a near-infrared ray furnace, a far-infrared ray furnace, and a vacuum heating press. The atmosphere used in this case, may be an air atmosphere, but an atmosphere in which the oxygen concentration is low or absent, that is, an inert gas atmosphere or reducing atmosphere, is preferable.

[Examples]

Test examples of the present invention are explained in detail below.

[Test Examples 1 to 23]

As shown in Tables, the conductive paste is made by mixing a binder, conductive particles, and an oxide film remover in a planetary mixer.

In this case, the weight ratio of the binder and conductive particles in each conductive paste is 1:9. Also, as shown in the tables, the part by weight of the curing agent in the binder is a value relative to 100 parts by weight of the thermosetting resin. The part by weight of the oxide film remover (using stearic acid) is a value relative to 100 parts by weight of the conductive particles.

Differential scanning calorimetry was performed on each of the binders and conductive particles using a measuring instrument DSC6220 produced by SII NanoTechnology Inc. under the conditions of a nitrogen atmosphere and a temperature elevation rate of 10 degrees C/min. The lowest exothermic peak temperature $T_1$ (degrees C) that is observed for the binder and the lowest endothermic peak temperature $t_1$ (degrees C) that is observed for the conductive particles are shown in Tables. In differential scanning calorimetry, a peak in which the heat quantity is not less than $\pm 1.5$ J/g is quantified as a peak, with peaks less than that being excluded from the standpoint of analytical precision.

Next, each obtained conductive paste is filled in through via holes of a prepreg (Risho prepreg ES-3305 manufactured by Risho Kogyo Co. Ltd.) having through via holes with a diameter of 0.2 mm and copper foil is laminated on both sides of the prepreg. A double-sided copper laminated plate is formed by performing hot pressing by a thermal press machine for 60 minutes at a press temperature of 220 degrees C at a pressure of 50 kg/cm$^2$ (=4.9 $\times$ 10$^6$ Pa), and circuits are formed thereon by etching to make a printed circuit board.

Measurement of via resistance value is performed for each obtained printed circuit board (denoted by the initial resistance value in the tables), the fusion splice between the conductive particles and between the conductive particles and the copper foil is evaluated, and a moisture resistance reflow test is carried out.

When the via resistance value is not higher than 20 m$\Omega$, it can be sufficiently used practically. Also, the fusion splice of the conductive particles is evaluated by observing a cross section of the printed circuit board at a magnification of 1000$\times$ with a JEOL scanning electron microscope. When Fusion splices are confirmed between the conductive particles and between the conductive particles and the copper foil, it is denoted with a $\bigcirc$, when those cannot be confirmed, it is denoted with an $\times$ in the tables. In the moisture resistance reflow test, reflow was performed at a peak temperature of 260 degrees C after being left in an environment of 65 degrees C and 95% RH for 96 hours, a changing rate of the via resistance values before/after the test is calculated based on the following equation, and written in the tables.

$$\text{Moisture resistance reflow test changing rate (\%)} = (\text{via resistance value after test}$$

$$- \text{via resistance value before test}) / \text{via resistance value before test} \times 100$$

If the moisture resistance reflow test changing rate is not more than 100%, it can be sufficiently used practically.

[Table 1]

[Table 2]

The abbreviations are explained below.

[Thermosetting Resins]

Ep807: Bisphenol F type epoxy resin manufactured by Japan Epoxy Resins Co., Ltd., trade name Epikote 807.

D-330: Multivalent acrylate monomer manufactured by Nippon Kayaku Co., Ltd., trade name KAYARAD D-330.

[Curing Agents]

225E: Polyaminoamide curing agent manufactured by Fuji Kasei Kogyo Co., Ltd., trade name TOHMIDE 225E.

2E4MZ: An imidazole-derived curing agent manufactured by Shikoku Chemicals Corporation, trade name 2E4MZ.

C11Z: An imidazole-derived curing agent manufactured by Shikoku Chemicals Corporation, trade name C11Z.

C17Z: An imidazole-derived curing agent manufactured by Shikoku Chemicals Corporation, trade name C 17Z.

2P4MHZ: An imidazole-derived curing agent manufactured by Shikoku Chemicals Corporation, trade name 2P4MHZ.

2PHZ: An imidazole-derived curing agent manufactured by Shikoku Chemicals Corporation, trade name 2PHZ.

IPU-22G: Manufactured by Okamura Oil Mill, Ltd., trade name IPU-22G

[Conductive Particles]

Conductive Particles 1: Average particle diameter 10 $\mu$m, exothermic peak: 118.6 degrees C, endothermic peaks: 129.6 degrees C ($t_1$), 192.8 degrees C, 372.4 degrees C and 403.8 degrees C.

Conductive Particles 2: Alloy particles manufactured by Mitsui Mining & Smelting Co., Ltd., consisting of 63 percent by weight Sn and 37 percent by weight Pb (average particle diameter 20 to 30 $\mu$m).

Conductive Particles 3: Alloy particles manufactured by Mitsui Mining & Smelting Co., Ltd., consisting of 42 percent by weight Sn and 58 percent by weight Bi (average particle diameter 5 $\mu$m).

Conductive Particles 4: Alloy particles manufactured by Mitsui Mining & Smelting Co., Ltd., consisting of 91 percent by weight Sn and 9 percent by weight Zn (average particle diameter 20 to 30 $\mu$m).

Conductive Particles 5: Alloy particles manufactured by Mitsui Mining & Smelting Co., Ltd., consisting of 89 percent by weight Sn, 8 percent by weight Zn and 3 percent by weight Bi (average particle diameter 20 to 30 $\mu$m).

Conductive Particles 6: Alloy particles manufactured by Mitsui Mining & Smelting Co., Ltd., consisting of 93 percent by weight Sn, 3.5 percent by weight Ag, 0.5 percent by weight Bi, and 3 percent by weight In (average particle diameter 20 to 30 $\mu$m).

Conductive Particles 7: Reduced copper powder manufactured by Mitsui Mining & Smelting Co., Ltd., (average particle diameter 5 $\mu$m).

None of the conductive Particles 2 to 7 have an exothermic peak.

Also, diethylene glycol monobutyl ether was used as a solvent without using a resin in test example 23.

The "Conductive Particles 1" mentioned above are mixed particles that mix alloy particles (I-a) and alloy particles (II-a) manufactured by the method below at a weight ratio of 75:25.

[Manufacturing Method of Conductive Particles (I-a)]

1.0 kg of Cu particles (with a purity not less than 99 percent by weight), 4.8 kg of Sn particles (with a purity not less than 99 percent by weight), 3.2 kg of Ag particles (with a purity not less than 99 percent by weight), 0.5 kg of Bi particles (with a purity not less than 99 percent by weight), and 0.5 kg of In particles (with a purity not less than 99 percent by weight) are put into a graphite crucible, and this particle mixture is heated until 1400 degrees C in a helium gas atmosphere of not less than 99 volume percent by a high-frequency-induction-heating device and melted. Next, this metal melt is guided to a helium atmosphere atomizing tank from the distal end of the graphite crucible. The melt is atomized by blowing helium gas (with a purity not less than 99 volume percent, oxygen concentration of less than 0.1 volume percent, and pressure of 2.5 MPa) from a gas nozzle that is provided at the vicinity of the distal end of the graphite crucible to obtain alloy particles. The cooling rate at this time is 2600 degrees C/sec. The alloy particles thus obtained, as a result of observing with a scanning electron microscope (Model S2700, Hitachi, Ltd.), are spherical. Then, the alloy particles are classified by an air classifier (Turbo Classifier TC-15N manufactured by Nissin Engineering Inc.) to obtain the alloy particles (I-a) with an average particle diameter of 10 $\mu$m.

The alloy particles (I-a) are subjected to differential scanning calorimetry using a differential scanning calorimetric analyzer DSC6220 produced by SII NanoTechnology Inc. The measurement was performed in a temperature range of 30 to 600 degrees C under a conduction of a nitrogen atmosphere and a temperature elevation rate of 10 degrees C/min. As a result, an exothermic peak of 118.6 degrees C was measured, and the alloy particles (I-a) was confirmed to have a metastable alloy phase. Also, endothermic peaks of 192.8 degrees C, 360.5 degrees C, and 415.3 degrees C were observed, and the alloy particles (I-a) was confirmed to have a plurality of melting points. The scanning calorimetry quantifies a peak with a heat amount of not less than $\pm$1.5 J/g as a peak derived from the alloy particles (I-a), with peaks less than that being excluded from the standpoint of analytical precision.

[Manufacturing Method of Conductive Particles (II-a)]

1.5 kg of Cu particles (with a purity not less than 99 percent by weight), 3.75 kg of Sn particles (with a purity not less than 99 percent by weight), 1.0 kg of Ag particles (with a purity not less than 99 percent by weight), and 3.75 kg of In particles (with a purity not less than 99 percent by weight) are put into a graphite crucible, and this particle mixture is heated until 1400 degrees C in a helium gas atmosphere of not less than 99 volume percent by a high-frequency-induction-heating device to be melted. Next, this metal melt is guided to a helium atmosphere atomizing tank from the distal end of the graphite crucible. The melt is atomized by blowing helium gas (with a purity not less than 99 volume percent, oxygen concentration of less than 0.1 volume percent, and pressure of 2.5 MPa) from a gas nozzle that is provided at the vicinity of the distal end of the graphite crucible to obtain alloy particles. The cooling rate at this time is 2600 degrees C/sec. The alloy particles thus obtained, as a result of observing with a scanning electron microscope (Model S2700, Hitachi Ltd.), are spherical. Then, the alloy particles are classified by an air classifier (Turbo Classifier TC-15N manufactured by Nissin Engineering Inc.) to obtain the alloy particles (II-a) with an average particle diameter

of 10 μm.

The alloy particles (II-a) are subjected to differential scanning calorimetry using a differential scanning calorimetric analyzer DSC6220 produced by SII NanoTechnology Inc. The measurement was performed in a temperature range of 30 to 600 degrees C under a conduction of a nitrogen atmosphere and a temperature elevation rate of 10 degrees C/min. As a result, an endothermic peak of 129.6 degrees C was measured, with no characteristic exothermic peak existing. The scanning calorimetry quantifies a peak with a heat amount of not less than ±1.5 J/g as a peak derived from the alloy particles (II-a), with peaks less than that being excluded from the standpoint of analytical precision.

From the result shown in Table 1 and Table 2, conductive pastes that satisfy the relationship of Equation (1), that is, $T_1 - t_1$ is higher than - 20 degrees C in the tables, all have a small via resistance value (initial resistance value), favorable fusion splice between the conductive particles and between the conductive particles and the copper foil, and sufficient conductivity. Also, the moisture resistance reflow test changing rates are small, and these were shown to have extremely excellent conductive connection reliability. On the other hand, in those pastes that does not satisfy the relationship of Equation (1), that is, $T_1 - t_1$ is not higher than -20 degrees C, the connection between conductive particles was considered to be blocked due to the curing of the thermosetting resin, leading to either a state of an extremely high via resistance value and poor conductive connection (insufficient conductivity), or a state in which even if the initial via resistance value is favorable, disconnections are observed after the moisture resistance reflow test, and the conductive connection reliability is inadequate. In the test example 23 that includes a solvent instead of a binder, initially the via resistance value is favorable and the conductive connection reliability is considered to be excellent. However, since a thermosetting resin is not contained, disconnections were observed after the moisture resistance reflow test, and the conductive connection reliability was poor.

Also, since the conductive particles 1 particularly are a particle mixture of alloy particles (I-a) that have an exothermic peak and alloy particles (II-a) that have an endothermic peak by differential scanning calorimetry, a metastable phase in the alloy particles (I-a) and a portion in the alloy particles (II-a) can be presumed to form a new phase by the pressing when the printed circuit board was manufactured (hot pressing for 60 minutes under the conditions of a press temperature of 220 degrees C at a pressure of 50 kg/cm$^2$ (=4.9 × 10$^6$ Pa)). As a result, the lowest melting point $t_1$ of the conductive particles 1 is a higher temperature than 129.6 degrees C in the printed circuit board, and so it can be presumed that the moisture resistance reflow test result is extremely favorable.

Moreover, from the results of test example 4 and test examples 15 to 21, by using a proper dosage of an oxide film remover, the fusion splice between the conductive particles and the fusion splice between the conductive particles and the copper foil increase, and the conductive connection reliability becomes even more excellent.

[Test Examples 24 to 30]

From the result shown in Table 1 and Table 2, it is clear that in the case of using the conductive particles 1 in which alloy particles (I-a) and alloy particles (II-a) are mixed at a weight ratio of 75:25, the moisture resistance reflow test result is favorable. Therefore, particle mixtures are prepared by changing the weight ratios, and except that the particle mixtures are used as conductive particles, printed circuit boards are fabricated and various measurements and evaluations are performed similarly to test example 6. The results are presented in Table 3.

[Table 3]

From the results of Table 3, in a wide range of weight ratios (weight ratios of alloy particles (I-a) and alloy particles (II-a)), it is clear that a low via resistance value (initial resistance value) and a low moisture resistance reflow test changing rate can be achieved. In particular, in the case of 40 to 90 percent by weight of the alloy particles (I-a) and 10 to 60 percent by weight of the alloy particles (II-a), the moisture resistance reflow test changing rate is small and the conductive connection reliability is more excellent.

[Test Examples 31 to 33]

Except that the weight ratios of the conductive particles 1 and the binders are changed, printed circuit boards are fabricated and various measurements and evaluations are performed similarly to test example 4. The results are presented in Table 4.

[Table 4]

From the results of Table 4, in a range of 3 to 16 percent by weight of the binder and 84 to 97 percent by weight of the conductive particles, it is clear that a low via resistance value (initial resistance value) and a low moisture resistance reflow test changing rate can be achieved.

INDUSTRIAL APPLICABILITY

By using the present conductive paste with favorable conductivity and excellent conductive connection reliability, it is possible to apply to uses for through via holes and non-through via holes provided on a multi-layer printed circuit board and to uses for mounted portions such as electronic components. The conductive paste is printed and filled in the via holes and then hardened by heat treatment. Thereby, the conductive particles are fusion spliced to each other in a highly dispersed state and favorably connect to the electrode metal portions of the substrate, enabling the manufacture of a multi-layer printed circuit board that has excellent conductive connection reliability.

Table 1

| | | Binder | | Oxide Film Remover | Conductive Particles | Differential Scanning Calorimetry | | | Evaluation Results | | |
|---|---|---|---|---|---|---|---|---|---|---|---|
| | | Thermosetting Resin | Curing Agent | | | $T_1$ (°C) | $t_1$ (°C) | $T_1 - t_1$ (°C) | Initial resistance value (mΩ) | Fusion splice | Moisture resistance reflow test changing rate (%) |
| Test Examples | 1 | Ep807 | 225E 100 pts.wt. | 0.5 pts.wt. | Conductive Particles 1 | 106.6 | 129.6 | -23.0 | 750.0 | × | — |
| | 2 | Ep807 | 2E4MZ 5 pts.wt. | 0.5 pts.wt. | Conductive Particles 1 | 125.9 | 129.6 | -3.7 | 4.0 | ○ | — |
| | 3 | Ep807 | C11Z 5 pts.wt. | 0.5 pts.wt. | Conductive Particles 1 | 137.4 | 129.6 | +7.8 | 3.2 | ○ | 8.0 |
| | 4 | Ep807 | C17Z 5 pts.wt. | 0.5 pts.wt. | Conductive Particles 1 | 142.3 | 129.6 | +12.7 | 2.6 | ○ | 7.4 |
| | 5 | Ep807 | 2P4MHZ 5 pts.wt. | 0.5 pts.wt. | Conductive Particles 1 | 164.0 | 129.6 | +34.4 | 2.5 | ○ | — |
| | 6 | Ep807 | 2PHZ 5 pts.wt. | 0.5 pts.wt. | Conductive Particles 1 | 185.4 | 129.6 | +55.8 | 2.3 | ○ | 7.6 |
| | 7 | D-330 | IPU-22G 50 pts.wt. | 0.5 pts.wt. | Conductive Particles 1 | 90.0 | 129.6 | -39.6 | 221.0 | × | — |
| | 8 | D-330 | -- | 0.5 pts.wt. | Conductive Particles 1 | 194.3 | 129.6 | +64.7 | 3.1 | ○ | 7.7 |
| | 9 | Ep807 | C17Z 5 pts.wt. | 0.5 pts.wt. | Conductive Particles 2 | 142.3 | 183.0 | -40.7 | 60.0 | × | — |
| | 10 | Ep807 | 2P4MHZ 5 pts.wt. | 0.5 pts.wt. | Conductive Particles 2 | 164.0 | 183.0 | -19.0 | 4.1 | ○ | 17.0 |
| | 11 | Ep807 | 2PHZ 5 pts.wt. | 0.5 pts.wt. | Conductive Particles 3 | 185.4 | 139.0 | +46.4 | 19.0 | ○ | 21.0 |
| | 12 | Ep807 | 2PHZ 5 pts.wt. | 0.5 pts.wt. | Conductive Particles 4 | 185.4 | 195.0 | -9.6 | 9.2 | ○ | 34.4 |

Table 2

| | | Binder | | Oxide Film Remover | Conductive Particles | Differential Scanning Calorimetry | | | Evaluation Results | | |
|---|---|---|---|---|---|---|---|---|---|---|---|
| | | Thermosetting Resin | Curing Agent | | | $T_1$ (°C) | $t_1$ (°C) | $T_1 - t_1$ (°C) | Initial resistance value (mΩ) | Fusion splice | Moisture resistance reflow test changing rate (%) |
| Test Examples | 13 | Ep807 | 2PHZ 5 pts.wt. | 0.5 pts.wt. | Conductive Particles 5 | 185.4 | 199.0 | -13.6 | 9.4 | ○ | 39.1 |
| | 14 | Ep807 | 2PHZ 5 pts.wt. | 0.5 pts.wt. | Conductive Particles 6 | 185.4 | 212.0 | -26.6 | 58.0 | × | — |
| | 15 | Ep807 | C17Z 5 pts.wt. | None | Conductive Particles 1 | 142.3 | 129.6 | +12.7 | 5.0 | ○ | 47.0 |
| | 16 | Ep807 | C17Z 5 pts.wt. | 0.05 pts.wt. | Conductive Particles 1 | 142.3 | 129.6 | +12.7 | 4.9 | ○ | 48.0 |
| | 17 | Ep807 | C17Z 5 pts.wt. | 0.10 pts.wt. | Conductive Particles 1 | 142.3 | 129.6 | +12.7 | 3.1 | ○ | 12.0 |
| | 18 | Ep807 | C17Z 5 pts.wt. | 0.25 pts.wt. | Conductive Particles 1 | 142.3 | 129.6 | +12.7 | 2.7 | ○ | 8.2 |
| | 19 | Ep807 | C17Z 5 pts.wt. | 1.00 pts.wt. | Conductive Particles 1 | 142.3 | 129.6 | +12.7 | 3.0 | ○ | 8.2 |
| | 20 | Ep807 | C17Z 5 pts.wt. | 3.00 pts.wt. | Conductive Particles 1 | 142.3 | 129.6 | +12.7 | 2.9 | ○ | 18.7 |
| | 21 | Ep807 | C17Z 5 pts.wt. | 4.00 pts.wt. | Conductive Particles 1 | 142.3 | 129.6 | +12.7 | 3.0 | ○ | 23.7 |
| | 22 | Ep807 | C17Z 5 pts.wt. | None | Conductive Particles 7 | 142.3 | 1083.4 | -941.1 | 2.1 | - | Calculation not possible due to disconnection after test |
| | 23 | Solvent instead of binder | None | 0.5 pts.wt. | Conductive Particles 1 | -- | 129.6 | -- | 2.8 | - | Calculation not possible due to disconnection after test |

EP 1 850 352 A1

Table 3

| | | Weight Ratio | | Differential Scanning Calorimetry | | | Evaluation Result | | |
|---|---|---|---|---|---|---|---|---|---|
| | | Alloy Particles (I-a) (wt%) | Alloy Particles (II-a) (wt%) | $T_1$ (°C) | $t_1$ (°C) | $T_1 - t_1$ (°C) | Initial resistance value (mΩ) | Fusion splice | Moisture resistance reflow test changing rate (%) |
| Test Examples | 24 | 0 | 100 | 185.4 | 129.6 | +55.8 | 9.2 | ○ | 38.1 |
| | 25 | 10 | 90 | 185.4 | 129.6 | +55.8 | 8.2 | ○ | 34.5 |
| | 26 | 20 | 80 | 185.4 | 129.6 | +55.8 | 4.8 | ○ | 29.1 |
| | 27 | 40 | 60 | 185.4 | 129.6 | +55.8 | 3.7 | ○ | 12.6 |
| | 28 | 50 | 50 | 185.4 | 129.6 | +55.8 | 2.4 | ○ | 8.2 |
| | 6 | 75 | 25 | 185.4 | 129.6 | +55.8 | 2.3 | ○ | 7.6 |
| | 29 | 90 | 10 | 185.4 | 129.6 | +55.8 | 2.6 | ○ | 17.8 |
| | 30 | 100 | 0 | 185.4 | 192.8 | -7.4 | 2.5 | ○ | 48.2 |

Table 4

| | | Weight Ratio | | Differential Scanning Calorimetry | | | Evaluation Result | | |
|---|---|---|---|---|---|---|---|---|---|
| | | Binder | Conductive Particles 1 | $T_1$ (°C) | $t_1$ (°C) | $T_1 - t_1$ (°C) | Initial resistance value (mΩ) | Fusion splice | Moisture resistance reflow test changing rate (%) |
| Test Examples | 31 | 16 | 84 | 142.3 | 129.6 | +12.7 | 5.8 | ○ | 9.3 |
| | 4 | 10 | 90 | 142.3 | 129.6 | +12.7 | 2.6 | ○ | 7.4 |
| | 32 | 6 | 94 | 142.3 | 129.6 | +12.7 | 2.2 | ○ | 8.2 |
| | 33 | 3 | 97 | 142.3 | 129.6 | +12.7 | 2.2 | ○ | 18.3 |

**Claims**

1. A conductive paste that includes a binder containing a thermosetting resin and conductive particles, wherein the lowest exothermic peak temperature $T_1$ (degrees C) among at least one exothermic peak of the binder obtained by differential scanning calorimetry and the lowest endothermic peak temperature $t_1$ (degrees C) among at least one endothermic peak of the conductive particles obtained by differential scanning calorimetry satisfy Equation (1)

$$t_1 - 20 < T_1 \cdots (1).$$

2. The conductive paste according to claim 1, wherein
the conductive particles preferably have at least one exothermic peak by differential scanning calorimetry.

3. The conductive paste according to claim 2, wherein
the conductive particles preferably have alloy particles (I) that have at least one exothermic peak by differential scanning calorimetry and alloy particles (II) that have an endothermic peak at the endothermic peak temperature $t_1$.

4. The conductive paste according to claim 1, wherein
the conductive paste contains 0.1 to 4.0 parts by weight of an oxide film remover relative to 100 parts by weight of the conductive particles.

5. The conductive paste according to claim 2, wherein
the conductive paste contains 0.1 to 4.0 parts by weight of an oxide film remover relative to 100 parts by weight of the conductive particles.

6. The conductive paste according to claim 3, wherein
the conductive paste contains 0.1 to 4.0 parts by weight of an oxide film remover relative to 100 parts by weight of the conductive particles.

7. The conductive paste according to any one of claims 1 through 6, wherein
the conductive paste is suitable for filling via holes in a printed circuit board.

## INTERNATIONAL SEARCH REPORT

| International application No. |
| --- |
| PCT/JP2006/300829 |

**A. CLASSIFICATION OF SUBJECT MATTER**
*H01B1/22*(2006.01), *H05K1/09*(2006.01)

According to International Patent Classification (IPC) or to both national classification and IPC

**B. FIELDS SEARCHED**

Minimum documentation searched (classification system followed by classification symbols)
*H01B1/22*(2006.01), *H05K1/09*(2006.01)

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2004-363052 A  (Asahi Kasei Corp.),<br>24 December, 2004 (24.12.04),<br>Full text<br>(Family: none) | 1-7<br>4-6 |
| X<br>Y | JP 2000-517092 A  (CRAIG, Hugh, P.),<br>19 December, 2000 (19.12.00),<br>Full text<br>& WO 98/8362 A1          & EP 933010 A | 1-7<br>4-6 |
| X<br>Y | JP 2003-305588 A  (Fujitsu Ltd.),<br>28 October, 2003 (28.10.03),<br>Full text<br>(Family: none) | 1-3,7<br>4-6 |

☒  Further documents are listed in the continuation of Box C.         ☐  See patent family annex.

| | |
| --- | --- |
| *     Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| | |
| --- | --- |
| Date of the actual completion of the international search<br>    24 April, 2006 (24.04.06) | Date of mailing of the international search report<br>    02 May, 2006 (02.05.06) |
| Name and mailing address of the ISA/<br>    Japanese Patent Office | Authorized officer |
| Facsimile No. | Telephone No. |

Form PCT/ISA/210 (second sheet) (April 2005)

**INTERNATIONAL SEARCH REPORT**

| | International application No. |
|---|---|
| | PCT/JP2006/300829 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | WO 2003/105160 A  (Tatsuta Electric Wire & Cable Co., Ltd.), 18 December, 2003 (18.12.03), Full text & CN 1656573 A | 1-3,7<br>4-6 |
| X<br>Y | JP 10-279902 A  (Asahi Chemical Industry Co., Ltd.), 20 October, 1998 (20.10.98), Full text (Family: none) | 1-3,7<br>4-6 |
| X<br>Y | JP 2004-234900 A  (Asahi Kasei Corp.), 19 August, 2004 (19.08.04), Full text (Family: none) | 1-2,7<br>4-5 |
| X<br>Y | JP 2004-63446 A  (Hitachi Chemical Co., Ltd.), 26 February, 2004 (26.02.04), Full text (Family: none) | 1-3,7<br>4-6 |
| X<br>Y | JP 2001-44590 A  (Kyocera Corp.), 16 February, 2001 (16.02.01), Full text & US 6207259 B1 | 1-2,7<br>4-5 |
| P,X | JP 2006-12734 A  (Tatsuta System Electronics Kabushiki Kaisha), 12 January, 2006 (12.01.06), Full text (Family: none) | 1-3,7 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005016965 A
- JP 2002094242 A
- JP 2004234900 A
- JP 2004223559 A
- JP 2004363052 A
- JP 2005005054 A
- JP 3038210 B
- JP 2603053 B